(19) Europäisches Patentamt
European Patent Office
Office européen des brevets

(11) EP 1 145 020 B1

(12) EUROPÄISCHE PATENTSCHRIFT

(45) Veröffentlichungstag und Bekanntmachung des Hinweises auf die Patenterteilung:
12.03.2003 Patentblatt 2003/11

(51) Int Cl.⁷: **G01R 15/24**

(21) Anmeldenummer: 99966854.4

(22) Anmeldetag: 13.12.1999

(86) Internationale Anmeldenummer:
**PCT/DE99/03976**

(87) Internationale Veröffentlichungsnummer:
**WO 00/037949 (29.06.2000 Gazette 2000/26)**

(54) **VERFAHREN UND ANORDNUNG ZUR OPTISCHEN ERFASSUNG EINES ELEKTRISCHEN STROMS ÜBER LICHTSIGNALE MIT UNTERSCHIEDLICHER WELLENLÄNGE**

METHOD AND ARRANGEMENT FOR OPTICALLY DETECTING AN ELECTRIC CURRENT USING LIGHT SIGNALS THAT HAVE DIFFERENT WAVELENGTHS

PROCEDE ET DISPOSITIF DE MESURE OPTIQUE D'UN COURANT ELECTRIQUE A L'AIDE DE SIGNAUX LUMINEUX AYANT DIFFERENTES LONGUEURS D'ONDE

(84) Benannte Vertragsstaaten:
**AT CH DE FR GB LI**

(30) Priorität: **22.12.1998 DE 19859448**

(43) Veröffentlichungstag der Anmeldung:
**17.10.2001 Patentblatt 2001/42**

(73) Patentinhaber: **SIEMENS AKTIENGESELLSCHAFT**
**80333 München (DE)**

(72) Erfinder:
• **WILLSCH, Michael**
**D-90762 Fürth (DE)**
• **BOSSELMANN, Thomas**
**D-91080 Marloffstein (DE)**
• **MOHR, Stephan**
**D-07747 Jena (DE)**

(56) Entgegenhaltungen:
EP-A- 0 210 716          EP-A- 0 657 740
WO-A-98/05975           WO-A-98/38517
DE-A- 19 544 778         US-A- 4 629 323

**Beschreibung**

Die Erfindung betrifft ein Verfahren zur optischen Erfassung eines elektrischen Stroms, bei dem mindestens erstes elliptisch polarisiertes Lichtsignal mit einer ersten Polarisation und einer ersten Wellenlänge sowie ein zweites elliptisch polarisiertes Lichtsignal mit einer zweiten Polarisation und einer von der ersten Wellenlänge verschiedenen zweiten Wellenlänge erzeugt werden, das erste und das zweite Lichtsignal in ein Faraday-Element eingespeist werden, die erste und die zweite Polarisation beim Durchlaufen des Faraday-Elements in Abhängigkeit von dem elektrischen Strom verändert werden, und aus den Polarisationsänderungen der beiden Lichtsignale ein Meßsignal für den elektrischen Strom abgeleitet wird.

Die Erfindung betrifft außerdem eine Anordnung zur optischen Erfassung eines elektrischen Stroms in einem elektrischen Leiter, wobei die Anordnung mindestens Sendemittel zur Erzeugung mindestens eines ersten elliptisch polarisierten Lichtsignals mit einer ersten Polarisation und einer ersten Wellenlänge sowie eines zweiten elliptisch polarisierten Lichtsignals mit einer zweiten Polarisation und einer von der ersten Wellenlänge verschiedenen zweiten Wellenlänge, ein dem elektrischen Leiter zugeordnetes Faraday-Element, das von dem ersten und dem zweiten Lichtsignal durchlaufen wird, wobei das Faraday-Element in Abhängigkeit von dem zu erfassenden elektrischen Strom und von einer wellenlängenabhängigen effektiven Verdet-Konstante eine Änderung der ersten und der zweiten Polarisation bewirkt, und eine Auswerteeinheit zur Ableitung eines Meßsignals für den zu erfassenden elektrischen Strom aus den Änderungen der ersten und der zweiten Polarisation umfaßt.

Ein solches Verfahren und eine solche Anordnung sind beispielsweise aus der *WO 98/38517 A1* und aus der *JP 5-264608 A2* bekannt. In der WO 98/38517 A1 wird eine Anordnung zur Strommessung beschrieben, bei der zwei Lichtsignale mit jeweils unterschiedlicher Wellenlänge erzeugt werden und über einen Koppler in einen Lichtwellenleiter eingespeist werden. Der Lichtwellenleiter dient als gemeinsame Zuführung zu einem Faraday-Element. Vor Eintritt in das Faraday-Element werden beide Lichtsignale linear polarisiert. Eine lineare Polarisation ist in diesem Zusammenhang als besonders günstige Sonderform einer elliptischen Polarisation zu betrachten. Im allgemeinen Fall ist jedoch jede andere elliptische Polarisationsform ist ebenso geeignet, solange sie eine ausgezeichnete Richtung aufweist. Das erste Lichtsignal hat eine Wellenlänge zwischen 630 und 850 nm und das zweite Lichtsignal hat eine Wellenlänge zwischen 1300 und 1550 nm. Aufgrund der wellenlängenabhängigen Verdet-Konstante werden die Polarisationen der beiden Lichtsignale in dem Faraday-Element unterschiedlich stark beeinflußt. Die Auswertung der durch den Strom hervorgerufenen Polarisationsänderungen erfolgt einkanalig oder zweikanalig. In einer Auswerteeinheit werden die beiden Lichtsignale durch optische Filterelemente oder durch den Empfindlichkeitsbereich der verwendeten Photodioden entsprechend ihrer Wellenlänge voneinander separiert und zur Weiterverarbeitung in elektrische Signale umgewandelt. Dabei bewirkt der Wellenlängenunterschied zwischen den beiden Lichtsignalen, daß das aus dem ersten Lichtsignal abgeleitete elektrische Signal eine eindeutige Funktion des zu messenden Stroms und das aus dem anderen Lichtsignal abgeleitete elektrische Signal eine nicht eindeutige, periodische Funktion des zu messenden Stroms ist. Das zweite abgeleitete elektrische Signal besitzt dafür jedoch eine höhere Meßauflösung. Aus diesen beiden elektrischen Signalen wird eine Meßgröße für den elektrischen Strom mit großem Meßbereich und auch mit hoher Meßauflösung abgeleitet. Das hierbei verwendete Verfahren ist aus der *DE 195 44 778 A1* bekannt.

In der DE 195 44 778 A1 wird ein magnetooptischer Stromwand-1er mit zwei Faraday-Elementen zur Ableitung zweier verschiedener Meßsignale beschrieben. Das erste Faraday-Element liefert ein erstes Meßsignal, das in einem vorgegebenen Meßbereich eine eindeutige Funktion des zu messenden elektrischen Stroms ist (= Betrieb im Eindeutigkeitsbereich). Das zweite Faraday-Element ist dagegen so beschaffen, daß ein von ihm erzeugtes zweites Meßsignal eine nicht eindeutige, im wesentlichen periodische Funktion des elektrischen Stroms ist (= Betrieb im Mehrdeutigkeitsbereich). Aus beiden Meßsignalen wird ein drittes Meßsignal für den elektrischen Strom zusammengesetzt, das in dem vorgegebenen Meßbereich sowohl eine eindeutige Funktion der Meßgröße ist als auch die gleiche hohe Meßauflösung wie das zweite Meßsignal aufweist. Das beschriebene Verfahren erfordert jedoch einen relativ hohen Aufwand, da zwei separate Faraday-Elemente zum Einsatz kommen und auch bei der Bildung des dritten Meßsignals in einer Auswerteeinheit ein hoher Rechenaufwand benötigt wird.

Aus der JP 05-264608 A2 ist eine Anordnung zur optischen Erfassung eines elektrischen Stroms bekannt, die sich ebenfalls zweier Lichtsignale mit unterschiedlicher Wellenlänge (660 nm und 880 nm) bedient. Das hierbei verwendete Faraday-Element ist ein magnetooptischer Volumenkristall, der in der Nähe eines stromdurchflossenen Leiters angeordnet ist. Die beiden Lichtsignale mit unterschiedlicher Wellenlänge werden bei dieser Anordnung jedoch nicht dazu verwendet, den Meßbereich zu erweitern. Vielmehr werden aus beiden Lichtsignalen elektrische Signale mit jeweils eindeutiger Zuordnung zu dem zu erfassenden elektrischen Strom abgeleitet. Das Faraday-Element wird bei beiden Wellenlängen im linearen Bereich der Kennlinie und somit im Eindeutigkeitsbereich betrieben. Damit ergibt sich ein relativ eingeschränkter Meßbereich.

Auch in der *EP 0 210 716 A1* wird ein magnetooptischer Stromsensor, der mit zwei Lichtsignalen unterschiedlicher Wellenlängen betrieben wird, beschrieben. Auch hier dienen die zwei Wellenlängen nicht einer Meßbereichserweiterung, sondern einer Driftkompensation. Das Faraday-Element wird wieder nur im linearen, d.h. eindeutigen Bereich der Kennlinie betrieben.

Außerdem werden in der *US 4,629,323* jeweils eine Anordnung zur optischen Stromerfassung und zur optischen Spannungserfassung beschrieben. In das sensitive Element, ein Faraday- bzw. ein Pockels-Element, werden jeweils Lichtsignale mit zwei voneinander verschiedenen Wellenlängen eingespeist. Auch hier dienen die Lichtsignale unterschiedlicher Wellenlänge einer Kompensation von Amplitudenschwankungen und nicht einer Meßbereichserweiterung.

Mit der *DE 31 41 325 A1* wird ein Heterodyn-Verfahren zur optischen Strommessung offenbart, bei dem zwei Lichtsignale mit gleicher Wellenlänge, jedoch unterschiedlicher Intensitätsmodulation erzeugt werden. Der Frequenzunterschied der Intensitätsmodulation zwischen beiden Lichtsignalen beträgt zwischen 1 kHz und 1 MHz. Aus diesen beiden Lichtsignalen wird ein weiteres Lichtsignal mit einem linearen Polarisationsvektor, der mit der Differenzfrequenz der beiden Intensitätsmodulationen um die Ausbreitungsrichtung des weiteren Lichtsignals rotiert, erzeugt. Das Lichtsignal mit rotierendem linearen Polarisationsvektor wird dann sowohl in ein Faraday-Element eingespeist als auch als Referenzsignal direkt zu einer Auswerteeinheit übertragen. Durch Phasenvergleich zwischen dem Referenzsignal und dem aus dem Faraday-Element austretenden Lichtsignal wird dann der elektrische Strom bestimmt. Auch mit diesem Verfahren läßt sich der Meßbereich für die optische Strommessung über den Eindeutigkeitsbereich hinaus erweitern. Wegen des Referenzsignals und der in der Auswerteeinheit benötigten Phasenvergleichsmeßgeräte ist dieses Verfahren jedoch relativ aufwendig.

In der *WO 98/05975 A1* werden ein Verfahren und eine Anordnung zur optischen Stromerfassung beschrieben, bei denen zwei optische Meßsignale in Abhängigkeit von dem zu messenden elektrischen Strom erzeugt werden. Die Abhängigkeit der beiden optischen Meßsignale von dem elektrischen Strom ist jeweils periodisch, wobei sich die beiden Perioden höchstens um den Faktor 2 voneinander unterscheiden. Aus den beiden optischen Meßsignalen werden Wertepaare abgeleitet, denen sich dann jeweils ein aktueller Wert des zu messenden elektrischen Stroms zuordnen läßt. Mit der in diesem Verfahren beschriebenen Vorgehensweise ist es ebenfalls möglich, den Meßbereich bei der optischen Stromerfassung zu erweitern. In der WO 98/05975 A1 finden sich jedoch keinerlei Hinweise auf konkrete Ausführungsformen, die sich beispielsweise durch eine besondere Effizienz auszeichnen.

Der Erfindung liegt somit die Aufgabe zugrunde, ein Verfahren und eine Anordnung zur optischen Erfassung eines elektrischen Stroms mit einer möglichst großen Meßauflösung und einem Meßbereich, der über den durch das verwendete Faraday-Element und die verwendete Lichtwellenlänge bestimmten Eindeutigkeitsbereich hinausgeht, anzugeben. Die optische Erfassung des elektrischen Stroms soll dabei außerdem möglichst effizient erfolgen.

Zur Lösung der das Verfahren betreffenden Aufgabe wird ein Verfahren zur optischen Erfassung eines elektrischen Stroms der eingangs bezeichneten Art entsprechend den Merkmalen des Patentanspruchs 1 angegeben.

Bei dem erfindungsgemäßen Verfahren werden die erste und die zweite Polarisation pro Ampère des zu erfassenden elektrischen Stroms jeweils um mindestens 0,0014° gedreht. Außerdem wird zumindest eine der beiden Polarisationen unter dem Einfluß eines maximal zu erfassenden elektrischen Stroms um mehr als 45° gedreht.

Die Erfindung beruht dabei auf der Erkenntnis, daß es für jedes Faraday-Element einen bevorzugten Empfindlichkeitsbereich gibt, in dem mit Hilfe von zwei Lichtsignalen unterschiedlicher Wellenlänge der Meßbereich auf besonders einfache und vor allem effiziente Weise erweitert werden kann. Hierbei spielt die spezielle Ausführungsform des Faraday-Elements keine Rolle, solange das Faraday-Element für beide Wellenlängen transparent ist. Alle bekannten Ausführungsformen können nämlich mit einem im Hinblick auf eine maximale Meßbereichserweiterung besonders günstigen Empfindlichkeitsbereich ausgelegt werden.

Wählt man das Faraday-Element so, daß die beiden Lichtsignale mit unterschiedlicher Wellenlänge unter dem Einfluß des zu messenden elektrischen Stroms um mehr als 0,0014°/A in ihrer Polarisation gedreht werden, so ergibt sich für einen zu erfassenden periodischen elektrischen Strom ein Eindeutigkeitsbereich von ≤ ca. 20 kA (=Effektivwert). Der Eindeutigkeitsbereich wird durch den Drehwinkelbereich von [-45°; +45°] bestimmt, in dem durch das Faraday-Element hervorgerufene Polarisationsdrehungen eindeutig sind. Der eindeutig zu erfassende Maximalwert des elektrischen Stroms berechnet sich dann mit der genannten Untergrenze für die Empfindlichkeit des Faraday-Elements zu:

$$\frac{45°}{0,0014°/A} \leq \text{ca. } 32\text{kA (=Maximalwert)}$$

Um nun eine Auflösung von beispielsweise kleiner als 10 A zu erreichen, wählt man den Eindeutigkeitsbereich möglichst klein. Dies wird durch die Wahl einer möglichst hohen Empfindlichkeit (deutlich über der Untergrenze von 0,0014°/A) erreicht. Im Eindeutigkeitsbereich ist dann eine sehr hohe Meßauflösung von z.B. < 1 A erzielbar.

Dennoch läßt sich trotz der hohen Empfindlichkeit dann aber immer noch ein maximal erfaßbarer elektrischer Strom von bis zu einigen 10 kA oder sogar bis zu 100-200 kA erreichen, da die beiden Lichtsignale mit unterschiedlicher Wellenlänge für eine Meßbereichserweiterung herangezogen werden können. Bei einem hohen elektrischen Strom bewirkt das Faraday-Element nämlich zumindest bei einem der beiden Lichtsignale eine Drehung der zugehörigen Polarisation um mehr als 45°. Dadurch überschreitet die Polarisationsänderung zumindest dieses Lichtsignals die Grenze des Eindeutigkeitsbereichs, so daß es zu Doppeldeutigkeiten kommt und damit die Möglichkeit für die gewünschte Messbereichserweiterung gegeben ist.

Aus den durch den zu messenden Strom bedingten Änderungen der ersten und der zweiten Polarisation läßt sich ein Wertepaar ableiten, dem in dem vorstehend angegebenen erweiterten Meßbereich (≤ 200 kA) ein eindeutiger Wert des elektrischen Stroms zugewiesen werden kann. Die Zuordnung kann dabei sowohl über eine zuvor abgespeicherte Look-Up-Tabelle, in der die Wertepaare mit zugehöriger elektrischer Stromstärke hinterlegt sind, oder auch über eine mathematische Formel erfolgen. Außerdem kann ein Wertepaar auch über einen mathematischen Suchalgorithmus mit hinterlegten Kennlinienfunktionen oder mit einem hinterlegten Modell des magnetooptischen Wandlers dem ursächlichen elektrischen Strom zugeordnet werden.

Der große Meßbereich und die hohe Auflösung bei kleinen Strömen, d.h. im Eindeutigkeitsbereich, entsprechen gerade den diesbezüglichen Anforderungen im Bereich der öffentlichen elektrischen Energieversorgung, so daß sich das Verfahren für einen solchen Einsatz besonders eignet.

Besondere Ausgestaltungen des Verfahrens nach der Erfindung ergeben sich aus den von Anspruch 1 abhängigen Unteransprüchen.

In einer vorteilhaften Ausgestaltung des Verfahrens unterscheiden sich ein erster und zweiter Drehwinkel, um die die erste bzw. zweite Polarisation im Faraday-Element gedreht werden, höchstens um einen Faktor 2 voneinander. Für einen möglichst großen Meßbereich ist es nämlich von Vorteil, wenn sich Kennlinien, die für die erste und die zweite Wellenlänge jeweils die Stromabhängigkeit beschreiben, möglichst wenig unterscheiden. Insbesondere ist es vorteilhaft, wenn die Periodizitäten der bei Vernachlässigung von Störgrößeneinflüssen in erster Näherung sinusförmigen Kennlinien möglichst nahe beieinanderliegen. Durch die genannte Bedingung erreicht man, daß sich die Perioden der beiden sinusförmigen Kennlinien höchstens um einen Faktor 2 unterscheiden.

Weiterhin ist es günstig, wenn sich die erste und die zweite Wellenlänge um nicht mehr als 15 % bezogen auf einen Mittelwert aus beiden Wellenlängen voneinander unterscheiden. Da die Empfindlichkeit des Faraday-Elements von der Wellenlänge abhängt, wird mit dem für die erste und zweite Wellenlänge angegebenen Bereich erreicht, daß der resultierende Meßbereich um mindestens eine Größenordnung größer ist als der Eindeutigkeitsbereich bei separater Auswertung des ersten oder des zweiten Lichtsignals.

Eine weitere Ausgestaltung betrifft die Einspeisung der beiden Lichtsignale in das Faraday-Element. Vorteilhaft passieren die beiden Lichtsignale mit unterschiedlicher Wellenlänge das Faraday-Element gemeinsam, d.h. gleichzeitig. Zur Auswertung wird beispielsweise eine optische Separation in die beiden Lichtsignale gemäß ihrer jeweiligen Wellenlänge vorgenommen. Damit liegen zu jedem Zeitpunkt Meßinformationen vor, die anhand der ersten und der zweiten Wellenlänge gewonnen werden. Aufgrund der (Licht-)Signalunterscheidung ausschließlich im Wellenlängenbereich handelt es sich bei dieser Ausgestaltung um ein Wellenlängen-Multiplex-Verfahren (Wavelength Domain Multiplex = WDM).

Es gibt jedoch auch eine Ausführungsform, in der das erste und das zweite Lichtsignal periodisch abwechselnd in das Faraday-Element eingespeist werden. In dieser Ausführungsform steht zu jedem Zeitpunkt immer nur die über eine der beiden Wellenlängen gewonnene Meßinformation zur Verfügung. Durch ein entsprechend schnelles Umschalten zwischen beiden Lichtsignalen können zwei nacheinander aufgenommene Meßinformationen aber trotzdem einem einzigen zu messenden Stromwert zugeordnet werden, insbesondere dann, wenn eine Umschaltfrequenz mindestens zweimal so groß ist wie ein Frequenzwert einer maximalen Oberwelle einer höchsten zu erfassenden Frequenzkomponente des elektrischen Stroms I. Eine optische Trennung der beiden Lichtsignale ist in dieser Ausführungsform nicht erforderlich. Aufgrund der Signalunterscheidung im Zeitbereich handelt es sich bei dieser Ausführungsform um ein Zeit-Multiplex-Verfahren (Time Domain Multiplex = TDM).

Vorteilhaft ist außerdem auch eine Ausführungsform, bei der ein optisches Wobbelsignal mit einer variierenden Wellenlänge durch das Faraday-Element geschickt wird. Ein solches Wobbelsignal läßt sich beispielsweise mit einer in der Wellenlänge durchstimmbaren Lichtquelle (Laserdiode, LED, SLD mit durchstimmbaren Transmissionsfilter, Tuneable Fiber Laser) erzeugen. Die schmalbandige variierende Wellenlänge des Wobbelsignals nimmt dabei Wellenlängenwerte zwischen der ersten und der zweiten Wellenlänge an. Man kann sich das optische Wobbelsignal als aus unendlich vielen Einzelsignalen mit jeweils voneinander verschiedenen Einzelwellenlänge zusammengesetzt vorstellen. Bei dieser Interpretation sind dann das erste und das zweite Lichtsignal mit der ersten bzw. zweiten Wellenlänge diejenigen Einzelsignale, bei denen sich die Richtung der Wellenlängenvariation gerade umkehrt. Aufgrund der Einspeisung von theoretisch unendlich vielen Einzelwellenlängen in das Faraday-Element, ergibt sich bei der Auswertung ein größerer Spielraum zur Erweiterung des Meßbereichs, da prinzipiell für alle Einzelwellenlängen eine Meßinformation mit jeweils voneinander verschiedener Abhängigkeit von dem zu detektierenden elektrischen Strom vorliegt.

Bevorzugt ist eine Ausgestaltung bei der die Variation der Wellenlänge des optischen Wobbelsignals im periodischen Wechsel erfolgt.

In einer weiteren vorteilhaften Ausgestaltung werden das erste Lichtsignal mit einer ersten Frequenz und das zweite Lichtsignal mit einer von der ersten Frequenz verschiedenen zweiten Frequenz in ihrer Intensität moduliert. Diese Intensitätsmodulation erfolgt bei der Erzeugung der beiden Lichtsignale. Dazu wird ein Versorgungsstrom, der eine Lichtquelle wie z.B. eine Laserdiode oder eine LED zur Lichtemission anregt, mit der entsprechenden Frequenz in seiner Amplitude variiert. Die beiden Lichtsignale mit voneinander verschiedener Wellenlänge und Intensitätsmodulation werden dann in das Faraday-Element eingespeist. Dies kann sowohl gleichzeitig als auch zyklisch abwechselnd erfolgen. Zur Auswertung werden die in den beiden Lichtsignalen enthaltenen Meßinformationen durch eine nach einer optoelektrischen Wandlung durchgeführte elektrische Bandpaßfilterung voneinander separiert. Die Mittenfrequenzen der Bandpaßfilter entsprechen dabei der jeweiligen Frequenz der Intensitätsmodulation. Eine optische Filterung der beiden Lichtsignale entfällt dadurch.

Die Lösung der Aufgabe bezüglich der Anordnung zur optischen Erfassung eines elektrischen Stroms entsprechend der eingangs bezeichneten Art ergibt sich aus den Merkmalen des unabhängigen Anspruchs 9.

Bei der erfindungsgemäßen Anordnung zur elektrischen Erfassung eines elektrischen Stroms in einem elektrischen Leiter weist die effektive Verdet-Konstante des Faraday-Elements für beide Wellenlängen einen Wert von mindestens 0,0014°/A auf, und das Faraday-Element dreht zumindest eine der beiden Polarisationen bei einem maximal zu erfassenden elektrischen Strom die um mehr als 45°.

Mit einer solchen Anordnung gelingt auf besonders einfache und auch effiziente Weise eine Erweiterung des Meßbereichs bei zugleich unverändert guter Meßauflösung.

Die Sendemittel zur Erzeugung der beiden Lichtsignale mit voneinander verschiedener Wellenlänge umfassen handelsübliche Lichtquellen wie beispielsweise zwei LEDs, zwei Laserdioden oder zwei SLDs (engl.: superluminescent diode). Diese Lichtquellen emittieren bevorzugt im infraroten Wellenlängenbereich bei ca. 800 nm oder bei ca. 1300 nm. Ein anderer Wellenlängenbereich ist jedoch genauso gut geeignet. Die möglichen emittierten Wellenlängen unterliegen dabei nur insofern einer Bedingung, als die effektive Verdet-Konstante des Faraday-Elements bei diesen Wellenlängen jeweils mindestens bei dem obengenannten Wert von 0,0014°/A liegen sollte.

Die Sendemittel zur Erzeugung der beiden elliptisch polarisierten Lichtsignale umfassen außerdem auch einen linearen Polarisator, falls das von Lichtquelle emittierte Licht unpolarisiert ist.

Das Faraday-Element kann als Faserspule z.B. aus einer Quarzglasfaser, als massiver Glasring z.B. aus Flintglas oder als magnetooptischer Volumeneinkristall z.B. aus einem BSO (Wismutsiliciumoxid), einem BGO (Wismutgermaniumoxid) oder einem YIG (Yttrium Iron Garnet) ausgeführt sein. Dabei kann sich der magnetooptische Volumeneinkristall auch in einem Luftspalt eines den elektrischen Leiter umschließenden, magnetischen Flußkonzentrators befinden.

Um die genannte Bedingung für die effektive Verdet-Konstante zu erfüllen, ist beispielsweise bei einer Faserspule aus einer Quarzglasfaser eine Windungszahl von mindestens 10 erforderlich, wenn die beiden verwendeten Wellenlängen in der Größenordnung von 800 nm liegen. Sind Wellenlängen in der Größenordnung von 1300 nm vorgesehen, dann ist entsprechend eine Windungszahl von mindestens 25 erforderlich. Ein geeigneter Glasring, bei dem die beiden Lichtsignale jeweils nur einmal um den elektrischen Leiter herumgeführt werden, besteht demgegenüber aus Flintglas. Hier kann beispielsweise Flintglas der Firma Schott mit der Typbezeichnung SF6 oder SF57 verwendet werden. Ein solcher Glasring ist für einen Betrieb bei Wellenlängen in der Größenordnung von 485 nm bestimmt. Wegen der im allgemeinen nicht vorhandenen Möglichkeit zur Erhöhung der Empfindlichkeit (=effektive Verdet-Konstante) über einen mehrmaligen Lichtumlauf erfüllt ein solcher Glasring trotz der gegenüber Quarzglas höheren materialspezifischen Empfindlichkeit von Flintglas die Bedingung für die Empfindlichkeitsuntergrenze (=0,0014°/A) erst bei deutlich kürzeren Wellenlängen, als dies bei einer Quarzglas-Faserspule der Fall ist. Freie Entwurfsparameter sind also die Geometrie (= z.B. Anzahl der Lichtumläufe) des Faraday-Elements, die materialspezifischen Eigenschaften des Faraday-Elements und die verwendeten Wellenlängen.

Die Auswertung der durch den zu messenden Strom bedingten Änderungen der ersten und der zweiten Polarisation wird in einer Auswerteeinheit vorgenommen. Die Auswerteeinheit ermittelt ein Wertepaar aus den Polarisationsänderungen und ordnet dem Wertepaar dann anhand einer hinterlegten Look-Up-Tabelle einen entsprechenden Wert des elektrischen Stroms zu. Die Auswerteeinheit kann dabei in analoger und/oder digitaler Schaltungstechnik realisiert sein. Insbesondere kann die Auswerteeinheit eine digitale Berechnungseinheit, beispielsweise in Form eines digitalen Signalprozessors, umfassen.

Auch eine bereits bestehende Anordnung zur optischen Strommessung kann auf einfache Weise im Meßbereich erweitert werden, da an dem eigentlichen optischen Pfad keinerlei Eingriff notwendig ist. Die Meßbereichserweiterung wird vielmehr alleine durch ein Austauschen der bestehenden Sende-, Empfangs- und Auswertemittel erreicht.

Vorteilhafte Ausgestaltungen der Anordnung sind in den von Anspruch 9 abhängigen Patentansprüchen angegeben. Die bereits obengenannten Vorteile für das Verfahren gelten für die Anordnung sinngemäß.

In einer bevorzugten Ausgestaltung umfassen die Sendemittel auch Mittel zur gleichzeitigen Einspeisung der beiden Lichtsignale in das Faraday-Element. Dabei kann es sich um einen Koppler handeln, der die von unterschiedlichen Lichtquellen stammenden Lichtsignale in einen gemeinsamen zum Faraday-Element führenden Lichtwellenleiter einspeist.

Bevorzugte Ausführungsbeispiele werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen:

Figur 1    eine Anordnung zur optischen Strommessung mit zwei gleichzeitig in ein Faraday-Element eingespeisten Lichtsignalen unterschiedlicher Wellenlänge,

Figur 2    eine Anordnung zur optischen Strommessung mit zwei abwechselnd in ein Faraday-Element eingespeisten Lichtsignalen unterschiedlicher Wellenlänge,

Figur 3    eine Anordnung zur Strommessung mit einem in ein Faraday-Element eingespeisten Lichtsignal variierender Wellenlänge und

Figur 4    eine Anordnung zur optischen Strommessung mit zwei gleichzeitig in ein Faraday-Element eingespeisten, intensitätsmodulierten Lichtsignalen unterschiedlicher Wellenlänge.

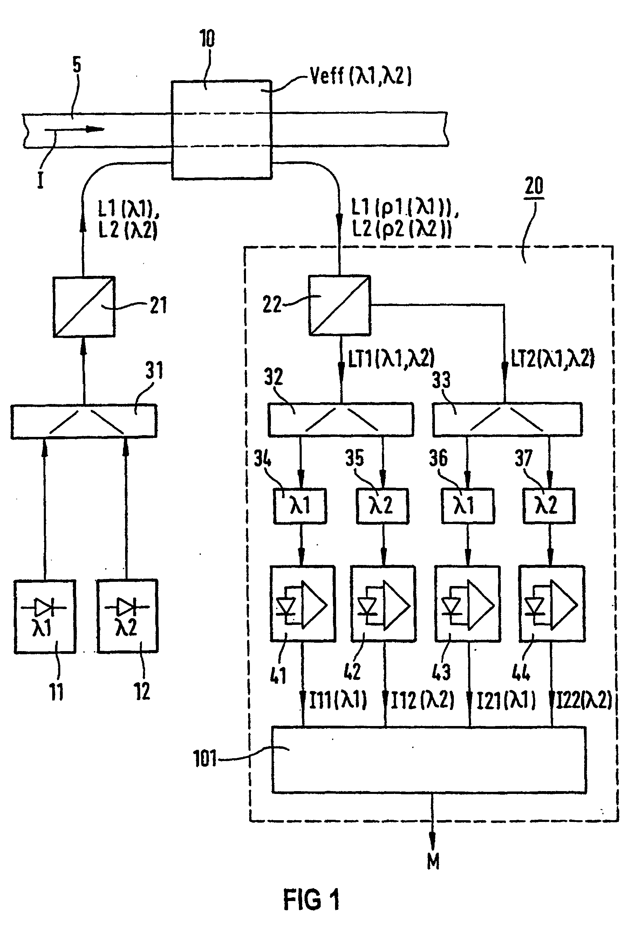

Einander entsprechende Teile sind in den Figuren 1 bis 4 mit denselben Bezugszeichen versehen.

In Figur 1 ist eine Anordnung zur optischen Messung eines in einem Stromleiter 5 fließenden elektrischen Stroms I dargestellt. In einer ersten Lichtquelle 11 und einer zweiten Lichtquelle 12 werden zwei Lichtsignale mit einer ersten Wellenlänge $\lambda 1$ bzw. einer zweiten Wellenlänge $\lambda 2$ erzeugt. Über einen Koppler 31, der vorliegend als 2x1-Faserkoppler ausgebildet ist, werden beide Lichtsignale einem Polarisator 21 zugeführt. An dessen Ausgang liegen dann ein erstes Lichtsignal L1 mit einer ersten linearen Polarisation und der ersten Wellenlänge $\lambda 1$ sowie ein zweites Lichtsignal L2 mit einer zweiten linearen Polarisation und der zweiten Wellenlänge $\lambda 2$ vor. Anstelle der linearen ist auch eine elliptische Polarisation mit einer Vorzugsrichtung möglich.

Die beiden linear polarisierten Lichtsignale L1 und L2 werden dann einem Faraday-Element 10, das dem Stromleiter 5 zugeordnet ist, zugeführt. Die Zuführung erfolgt dabei gemeinsam, beispielsweise über einen nicht näher dargestellten Lichtwellenleiter. In einem anderen nicht dargestellten Ausführungsbeispiel wird die lineare Polarisation der beiden Lichtsignale erst unmittelbar vor Eintritt in das Faraday-Element 10 erzeugt.

In dem Faraday-Element 10 werden die lineare erste und zweite Polarisation des ersten bzw. zweiten Lichtsignals L1 bzw. L2 um einen ersten bzw. zweiten Drehwinkel $\rho 1$ bzw. $\rho 2$ gedreht. Die Drehwinkel $\rho 1$ und $\rho 2$ sind dabei jeweils abhängig von der Größe des elektrischen Stroms I und von einer durch das Faraday-Element 10 bestimmten Konstante, einer sogenannten Verdet-Konstante V. Die Verdet-Konstante V ist von einem im Faraday-Element 10 verwendeten Material, von einer Umgebungstemperatur und von einer durch das Faraday-Element 10 hindurchgestrahlten Lichtwellenlänge $\lambda$ abhängig. Insbesondere die Abhängigkeit von der Lichtwellenlänge $\lambda$ ist für das in Figur 1 dargestellte Ausführungsbeispiel eines magnetooptischen Stromwandlers mit erweitertem Meßbereich von besonderer Bedeutung. Folgender empirisch ermittelter Zusammenhang kann für die Wellenlängenabhängigkeit der Verdet-Konstante V angegeben werden:

$$V(\lambda) = \frac{180°}{\lambda} \cdot \frac{n^2(\lambda) - 1}{n(\lambda)} \cdot \left( A + \frac{B}{\lambda^2 - \lambda_C^2} \right) \ , \qquad (1)$$

wobei $n(\lambda)$ eine wellenlängenabhängige Brechzahl des verwendeten Materials sowie A, B und $\lambda_C$ Materialkonstante, die beispielsweise einem einschlägigen Tabellenwerk entnommen werden können, bezeichnen.

Für ein als Faserspule mit N Windungen ausgebildetes Faraday-Element 10 ergibt sich dann der erste Drehwinkel $\rho 1$ für das erste Lichtsignal L1 zu:

$$\rho 1 = N \cdot V(\lambda 1) \cdot I \ . \qquad (2)$$

Für das zweite Lichtsignal mit der zweiten Lichtwellenlänge $\lambda 2$ ergibt sich entsprechend ein zweiter Drehwinkel $\rho 2$ von:

$$\rho 2 = N \cdot V(\lambda 2) \cdot I \ . \qquad (3)$$

Aus der wellenlängenabhängigen Verdet-Konstante V und der Windungszahl N kann man eine effektive Verdet-Konstante Veff bilden, so daß der erste und der zweite Drehwinkel $\rho 1$ bzw. $\rho 2$ ausschließlich von dieser wellenlängenabhängigen effektiven Verdet-Konstante Veff und dem zu messenden elektrischen Strom I abhängen. Entsprechend läßt sich auch für andere Ausführungsformen des Faraday-Elements 10, beispielsweise einen Glasring oder einen magnetooptischen Volumenkristall, eine effektive Verdet-Konstante Veff definieren, die die jeweiligen geometrieabhängigen Einflußgrößen dann mit umfaßt.

In der Fachliteratur findet sich auch eine von den Gleichungen (2) und (3) verschiedene Definition der Verdet-Konstante V als materialspezifische wellenlängenabhängige Proportionalitätskonstante, die den Zusammenhang zwischen dem Drehwinkel und dem Produkt aus magnetischer Induktion und Lichtweglänge angibt. Beide Definitionen der Verdet-Konstante V lassen sich jedoch auf einfache Weise ineinander umrechnen.

Nach Durchlaufen des Faraday-Elements 10 werden die beiden in ihrer Polarisation gedrehten Lichtsignale L1 und L2 in einer Auswerteeinheit 20 ausgewertet. In einem Analysator 22, der im vorliegenden Fall als Wollaston-Prisma ausgebildet ist, werden die beiden Lichtsignale L1 und L2 zunächst in zwei Lichtteilsignale LT1 und LT2 mit zueinander senkrechten Polarisationsebenen aufgeteilt. Dies entspricht der vorstehend als "zweikanalig" bezeichneten Auswertung. Läßt der Analysator 22 in einem nicht dargestellten anderen Ausführungsbeispiel die beiden in ihrer Polarisation gedrehten Lichtsignale L1 und L2 nur bezüglich einer Polarisationsebene passieren, so liegt dagegen eine einkanalige Auswertung vor.

Über Koppler 32 und 33 sowie auf die erste und zweite Wellenlänge abgestimmte optische Transmissionsfilter 34, 35, 36 und 37 werden die beiden Lichtteilsignale LT1 und LT2 in wellenlängenselektive Anteile zerlegt. Über optoelektrische Wandlereinheiten 41, 42, 43 und 44 werden diese in elektrische Signale I11, I12, I21 und I22 umgewandelt, die jeweils eine Information über den von dem zu messenden Strom I bei der jeweiligen Wellenlänge $\lambda1$ und $\lambda2$ verursachten ersten bzw. zweiten Drehwinkel $\rho1$ bzw. $\rho2$ beinhalten. Die optischen Transmissionsfilter 34, 35, 36 und 37 sind als Interferenzfilter ausgeführt. Sie können jedoch ebenfalls als Kantenfilter realisiert werden. Die optoelektrischen Wandlereinheiten 41, 42, 43 und 44 beinhalten jeweils eine auf die entsprechende Wellenlänge $\lambda1$ oder $\lambda2$ abgestimmte Photodiode und einen nachgeschalteten Transimpedanzverstärker.

In einer Signalverarbeitungseinheit 101 wird aus den elektrischen Signalen I11, I12, I21 und I22 ein Meßsignal M für den elektrischen Strom I abgeleitet. Zur Beseitigung von Störgrößeneinflüssen ist in der Signalverarbeitungseinheit 101 vor der eigentlichen Auswertung zunächst eine Intensitätsnormierung vorgesehen. Diese ist jedoch nicht zwingend notwendig, sie kann auch entfallen. Die sich anschließende eigentliche Ermittlung des Meßsignals M erfolgt nach einem aus dem Stand der Technik bekannten Verfahren. Die Signalverarbeitungseinheit 101 enthält zur Durchführung dieser Ermittlung auch eine digitale Berechnungseinheit in Form eines digitalen Signalprozessors.

Bei Vernachlässigung der in diesem Zusammenhang nicht interessierenden Störgrößeneinflüsse besitzen die elektrischen Signale I11, I12, I21 und I22 eine im wesentlichen sinusförmige Abhängigkeit vom doppelten ersten oder zweiten Drehwinkel $\rho1$ bzw. $\rho2$. Somit erhält man einen durch die Sinus-Funktion bestimmten Eindeutigkeitsbereich für den zu messenden elektrischen Strom I. Der Meßbereich ist zunächst auf diesen Eindeutigkeitsbereich begrenzt. Die in Figur 1 dargestellte Anordnung dient jedoch gerade dazu, den Meßbereich in besonders einfacher und effizienter Weise über diesen Eindeutigkeitsbereich hinaus zu erweitern.

Zu diesem Zweck ist das Faraday-Element 10 gerade so dimensioniert, daß für seine effektive Verdet-Konstante Veff bei beiden Lichtwellenlängen $\lambda1$ und $\lambda2$ gilt:

$$\text{Veff} \geq 0,0014°/\text{A}. \tag{4}$$

Der in Gleichung (1) angegebenen Abhängigkeit der Verdet-Konstante V von der Wellenlänge $\lambda$ liegt prinzipiell eine Proportionalitätsbeziehung gemäß:

$$V(\lambda) \propto \frac{1}{\lambda^2} \tag{5}$$

zugrunde. Dies wird offensichtlich, wenn in Gleichung (1) auch die Wellenlängenabhängigkeit der Brechzahl $n(\lambda)$ mit in Betracht gezogen wird. Für ein als Faserspule oder Glasring ausgebildetes Faraday-Element 10 läßt sich mit Gleichung (5) für die effektive Verdet-Konstante Veff folgende Beziehung:

$$\text{Veff}(\lambda) = V_0 \cdot N \cdot \left(\frac{\lambda_0}{\lambda}\right)^2 \tag{6}$$

ableiten, wobei $V_0$ einen bei einer gegebenen Wellenlänge $\lambda_0$ bekannten Wert der Verdet-Konstante V bezeichnet. Das Wertepaar $(V_o, \lambda_o)$ ist dabei materialspezifisch. N steht allgemein für die Anzahl der geschlossenen Umläufe der beiden Lichtsignale L1 oder L2 um den elektrischen Leiter 5. Bei einer Faserspule entspricht N dann wie bereits im Zusammenhang mit den Gleichungen (2) und (3) angegeben der Windungszahl. In einem Glasring wird das Licht dagegen im allgemeinen nur einmal um den stromdurchflossenen Leiter 5 herumgeführt, so daß N hier den Wert eins annimmt.

Für Quarzglas und Flintglas als lichtführende Medien sind beispielsweise bei einer Wellenlänge $\lambda_o$ von 820 nm eine Verdet-Konstante $V_0$ von etwa 0,00015°/A bzw. von etwa 0,00075°/A bekannt. Setzt man diese Materialparameter in Gleichung (6) ein und berücksichtigt man außerdem die Anforderung an die Mindestempfindlichkeit gemäß Gleichung (4), so erhält man eine Dimensionierungsvorgabe für das Faradayelement 10. Freie Parameter sind dabei die Anzahl der Lichtumläufe und die Wellenlänge $\lambda$.

Für eine bei 820 nm betriebene Faserspule aus einer Quarzglasfaser ergibt sich somit eine Windungszahl von mindestens 10. Entsprechend ergibt sich für eine bei der gleichen Wellenlänge betriebene Faserspule aus einer Flintglasfaser eine Windungszahl von mindestens 2. Für einen Flintglasring (N=1) erhält man dagegen als Vorgabe eine höchste mögliche Betriebswellenlänge von 600 nm.

Das in Figur 1 gezeigte Faraday-Element 10 ist als Faserspule aus einer Quarzglasfaser mit einer Windungszahl N $\geq$ 10 ausgeführt. Die beiden Lichtwellenlängen $\lambda 1$ und $\lambda 2$ betragen 780 nm bzw. 840 nm. Die erste und zweite Lichtquelle 11 bzw. 12 sind Laserdioden, die bei den angegebenen Wellenlängen schmalbandige CW-Lichtsignale emittieren.

Für eine Erweiterung des Meßbereichs gegenüber dem Eindeutigkeitsbereich um mindestens eine Größenordnung ist es nämlich vorteilhaft, wenn der Unterschied zwischen der ersten und der zweiten Lichtwellenlänge $\lambda 1$ bzw. $\lambda 2$ möglichst klein ist. Um einen möglichst großen Meßbereich zu erhalten, werden deshalb die erste und die zweite Wellenlänge $\lambda 1$ bzw. $\lambda 2$ so gewählt, daß ihre Wellenlängendifferenz höchstens 15 % des arithmetischen Mittelwerts aus beiden Wellenlängen $\lambda 1$ und $\lambda 2$ beträgt.

In einem nicht dargestellten Ausführungsbeispiel, in dem die beiden Wellenlängen $\lambda 1$ und $\lambda 2$ in der Größenordnung von 1300 nm liegen, hat die als Faraday-Element 10 eingesetzte Faserspule dann mindestens 25 Windungen, um die obengenannte Bedingung für die effektive Verdet-Konstante Veff zu erfüllen.

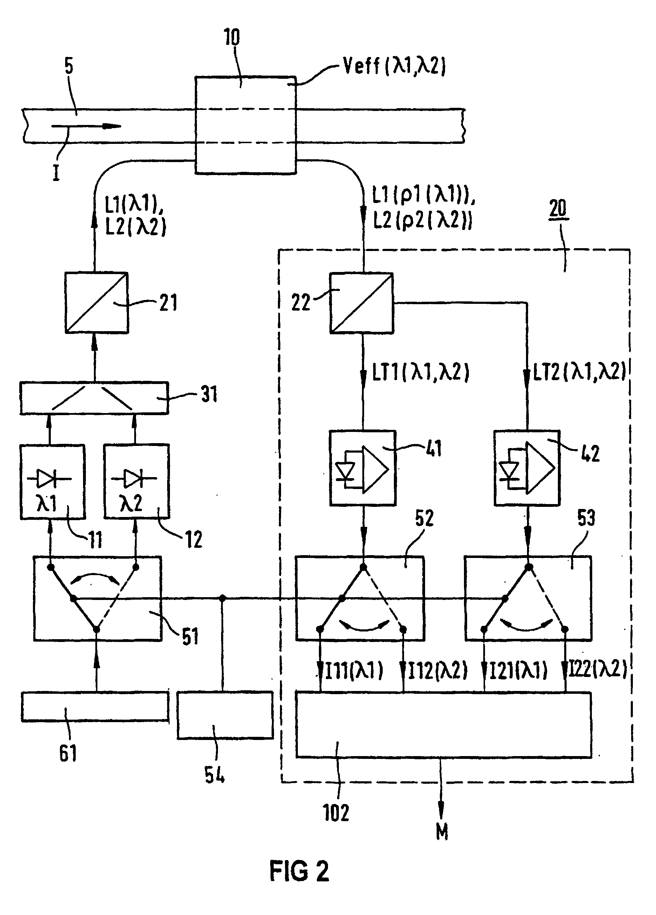

Bei der in Figur 2 dargestellten Anordnung zur Erfassung eines elektrischen Stroms I werden die beiden Lichtsignale L1 und L2 nicht gleichzeitig, sondern zyklisch abwechselnd in das Faraday-Element 10 eingespeist. Dazu sind die Lichtquellen 11 und 12 über einen Sendeumschalter 51 an eine Stromquelle 61, über die die Lichtquellen 11 und 12 versorgt und zur Lichtemission angeregt werden, angeschlossen. Der Sendeumschalter 51 wird von einer Steuereinheit 54 so gesteuert, daß nur jeweils eine der beiden Lichtquellen 11 oder 12 mit Strom versorgt wird und somit Licht emittiert. Der Sendeumschalter 51 und die Steuereinheit 54 ermöglichen somit eine zyklisch abwechselnde Einspeisung der beiden Lichtsignale L1 und L2 in das Faraday-Element 10. Bezeichnet man außerdem die Betriebsweise der in Figur 1 gezeigten Anordnung als Wellenlängen-Multiplex, so stellt die Betriebsweise der Anordnung von Figur 2 entsprechend einen Zeit-Multiplex-Betrieb dar.

Da die beiden Lichtsignale L1 und L2 mit unterschiedlicher Wellenlänge $\lambda 1$ und $\lambda 2$ das Faraday-Element 10 nicht gleichzeitig passieren, werden in der Auswerteeinheit 20 auch keine optischen Mittel zur Wellenlängenseparation benötigt. Die elektrischen Signale I11, I12, I21 und I22, die die Meßinformation über den elektrischen Strom I in Abhängigkeit von jeweils nur einer der beiden Wellenlängen $\lambda 1$ und $\lambda 2$ tragen, werden dadurch gewonnen, daß zwischen die optoelektrischen Wandlereinheiten 41 und 42 und eine Signalverabeitungseinheit 102 Empfangsumschalter 52 bzw. 53 geschaltet werden. Die Empfangsumschalter 52 und 53 werden durch die Steuereinheit 54 mit dem gleichen Takt umgeschaltet wie der Sendeumschalter 51.

Eine Synchronisierung des Sendeumschalters 51 und der Sendeumschalter 52 und 53 ist problemlos möglich, da sich die Auswerteeinheit 20 und auch die Sendemittel zur Erzeugung der beiden Lichtsignale L1 und L2 üblicherweise in naher lokaler Nachbarschaft, insbesondere sogar in ein und demselben Baugruppengehäuse befinden.

Die Weiterverarbeitung der elektrischen Signale I11, I12, I21 und I22 erfolgt analog zu dem Ausführungsbeispiel von Figur 1. Ebenso sind die Parameter für die verwendeten Lichtwellenlängen $\lambda 1$ und $\lambda 2$ sowie für die effektive Verdet-Konstante Veff analog zu dem Ausführungsbeispiel von Figur 1 gewählt.

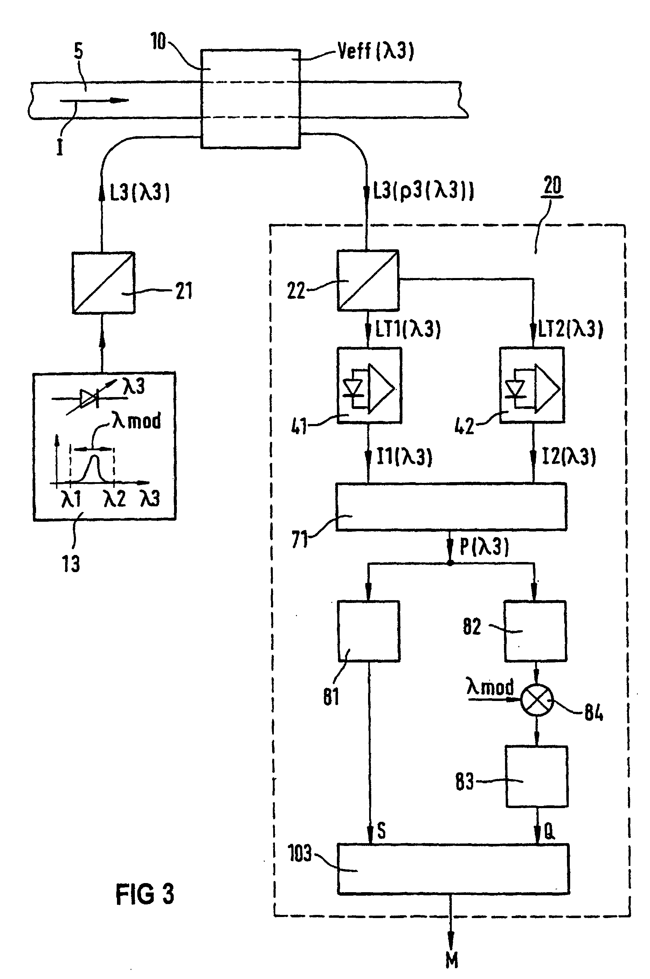

Die Anordnung des Ausführungsbeispiels von Figur 3 bedient sich anstelle zweier Lichtsignale L1 und L2 mit jeweils unterschiedlicher erster bzw. zweiter Wellenlänge $\lambda 1$ und $\lambda 2$ eines optischen Wobbelsignals L3 mit variierender Lichtwellenlänge $\lambda 3$. Die variierender Lichtwellenlänge $\lambda 3$ nimmt dabei periodisch Werte zwischen der ersten und der zweiten Wellenlänge $\lambda 1$ bzw. $\lambda 2$ an. Als Sendemittel zur Erzeugung des optischen Wobbelsignals L3 dient eine in der emittierten Wellenlänge durchstimmbare Lichtquelle 13, die mit einem entsprechenden Wellenlängenmodulationssignal $\lambda$mod moduliert wird.

Die Lichtquelle 13 ist als verstimmbarer Faser-Laser (Tuneable Fiber Laser = TFL) ausgebildet, dessen emittierte schmalbandige Wellenlänge um eine zentrale Wellenlänge von z.B. 810 nm variiert werden kann. Die erste und zweite Wellenlänge $\lambda 1$ bzw. $\lambda 2$ werden dabei wiederum so gewählt, daß die Wellenlängendifferenz maximal 15 % der zentralen Wellenlänge beträgt. Im Ausführungsbeispiel von Figur 3 hat die erste Wellenlänge $\lambda 1$ einen Wert von 800 nm und die zweite Wellenlänge $\lambda 2$ einen Wert von 820 nm. Alternative Sendemittel zur Erzeugung des optischen Wobbelsignals L3 sind eine breitbandig emittierende Lichtquelle wie z.B. eine Superlumineszenzdiode (SLD) und ein nachgeschaltetes modulierbares schmalbandiges Transmissionsfilter. Das Transmissionsfilter kann dabei sowohl am Sender als auch am Empfänger angeordnet sein.

In dem Faraday-Element 10 wird die Polarisation des optischen Wobbelsignals L3 in Abhängigkeit von dem elektrischen Strom I und von der variierenden Lichtwellenlänge $\lambda$3 um einen dritten Drehwinkel $\rho$3 gedreht. Wegen der variierenden Lichtwellenlänge $\lambda$3 liegt diesem Drehwinkel $\rho$3 anstelle einer konstanten hier auch eine variierende Kennlinie zugrunde. In der Auswerteeinheit 20 erfolgt zunächst durch die optoelektrischen Wandlereinheiten 41 und 42 eine Umwandlung der beiden Lichtteilsignale LT1 bzw. LT2 in elektrische Signale I1 bzw. I2, aus denen in einer Normierungseinheit 71 ein normiertes Signal P erzeugt wird. Das normierte Signal P trägt die Meßinformation über den elektrischen Strom I immer noch in Abhängigkeit der variierenden Wellenlänge $\lambda$3. Durch eine Filterung des normierten Signals P in einem ersten Tiefpaß 81 erhält man ein Mittelwertsignal S, das einer mittleren Kennlinie der Kennlinienvariation entspricht.

Aus dem normierten Signal P wird außerdem in einem Hochpaß 82 ein dem Hub der Kennlinienvariation entsprechender Variationsanteil extrahiert. Dieser Hub der Kennlinienvariation um die mittlere Kennlinie wird dabei durch das Wellenlängenmodulationssignal $\lambda$mod bestimmt. In einem Multiplikator 84 wird deshalb der Variationsanteil mit dem Wellenlängenmodulationssignal $\lambda$mod überlagert und anschließend in einem zweiten Tiefpaß 83 gefiltert. Mit dieser aus der Quadraturdemodulation bekannten Vorgehensweise wird ein Quadrantensignal Q ermittelt. Dieses trägt ebenso wie das Mittelwertsignal S eine (mehrdeutige) Meßinformation über den elektrischen Strom I.

Aus dem Mittelwertsignal S und dem Quadrantensignal Q ermittelt eine Signalverarbeitungseinheit 103 das Meßsignal M für den elektrischen Strom I. Dies erfolgt über eine in der Signalverarbeitungseinheit 103 hinterlegte Look-up-Tabelle.

Die durch das Wellenlängenmodulationssignal $\lambda$mod bestimmte periodische Variation der Wellenlänge $\lambda$3 zwischen der ersten und der zweiten Wellenlänge ist sinusförmig. Sie kann jedoch auch sägezahnförmig oder mit einer anderen periodischen Signalform verlaufen. Eine Modulationsfrequenz Fmod des Wellenlängenmodulationssignals $\lambda$mod hat dabei einen Frequenzwert, der mindestens doppelt so groß ist wie der einer maximalen Oberwelle einer höchsten zu erfassenden Frequenzkomponente des elektrischen Stroms I. Sobald die sinusförmige Kennlinie des Faradayelements 10 über den linearen Bereich hinaus ausgesteuert wird, entstehen nämlich Oberwellenanteile (=Bessel-Anteile), deren Frequenz um so höher liegen, je höher die Aussteuerung ist. Die vorstehende Frequenz-Bedingung gilt analog für eine Umschaltfrequenz der in Figur 2 gezeigten Anordnung. Im Beispiel von Figur 3 hat die Modulationsfrequenz Fmod einen Wert von beispielsweise 200 kHz.

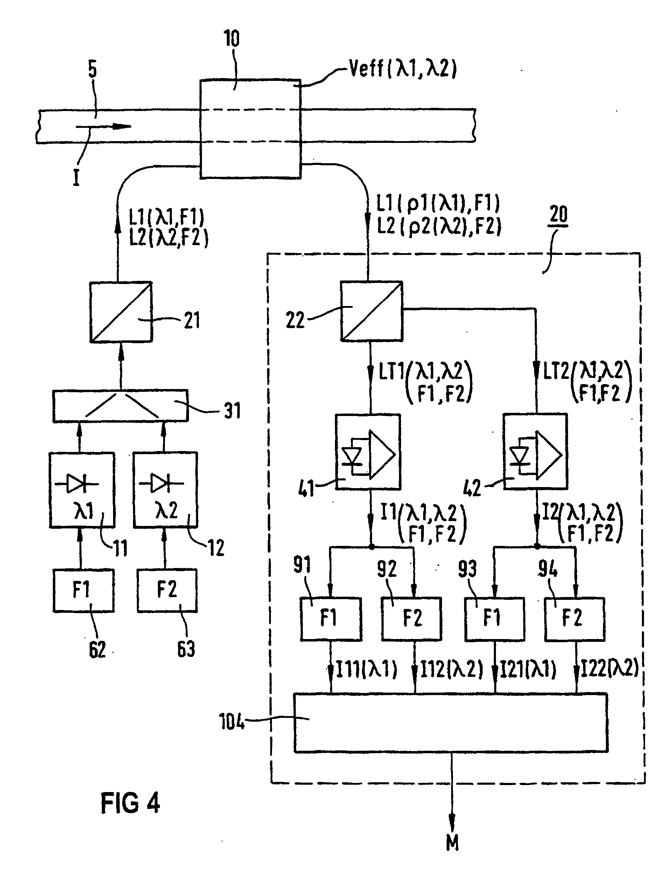

In Figur 4 ist eine Anordnung zur optischen Erfassung des elektrischen Stroms I dargestellt, bei der die Lichtquellen 11 und 12 über modulierbare Stromquellen 62 und 63 versorgt werden. Die modulierbaren Stromquellen 62 und 63 stellen den Lichtquellen 11 bzw. 12 ein in der Amplitude mit einer ersten Frequenz F1 bzw. mit einer zweiten Frequenz F2 rechteck-, sinus- oder sägezahnförmig moduliertes Stromsignal zur Verfügung. Diese modulierten Stromsignale veranlassen die erste und die zweite Lichtquelle 11 bzw. 12 zur Emission optischer Signale, die mit der ersten bzw. zweiten Frequenz F1 bzw. F2 in der Intensität moduliert sind. Die modulierbaren Stromquellen 62 und 63 lassen sich damit als Modulationsmittel zur Intensitätsmodulation der beiden Lichtsignale L1 und L2 auffassen.

Ein Frequenzunterschied zwischen den beiden Frequenzen F1 und F2 liegt dabei vorteilhafterweise zwischen 1 kHz und 1 MHz.

Dadurch wird ein Übersprechen sicher vermieden. Im vorliegenden Fall ist für die erste Frequenz F1 ein Wert von 200 kHz und für die zweite Frequenz F2 ein Wert von 300 kHz vorgesehen. In einem anderen Ausführungsbeispiel haben die erste und die zweite Frequenz F1 bzw. F2 einen Wert von 50 bzw. 60 kHz. Die beiden Frequenzen F1 und F2 sind dabei wiederum so gewählt, daß ihr jeweiliger Frequenzwert mindestens doppelt so groß ist wie der der maximalen Oberwelle der höchsten zu erfassenden Frequenzkomponente des elektrischen Stroms I.

Die in das Faraday-Element 10 eingespeisten ersten und zweiten Lichtsignale L1 und L2 unterscheiden sich also außer durch ihre Wellenlänge auch durch die Frequenz ihrer Intensitätsmodulation. Die Einspeisung der beiden Lichtsignale L1 und L2 erfolgt analog zu dem Ausführungsbeispiel von Figur 1 gleichzeitig. Es liegt also wiederum ein Wellenlängen-Multiplex-Betrieb vor, allerdings hier mit zusätzlicher Intensitätsmodulation.

In der Auswerteeinheit 20 werden die elektrischen Signale I11, I12, I21 und I22, die die wellenlängenbezogene Meßinformation über den elektrischen Strom I enthalten, durch eine elektrische Bandpaßfilterung erzeugt. Die von den elektrooptischen Wandlereinheiten 41 und 42 aus den beiden Lichtteilsignalen LT1 und LT2 generierten elektrischen Signale I1 und I2 werden dazu ersten Bandpässen 91 bzw. 93 mit einer der ersten Frequenz F1 entsprechenden Mittenfrequenz und zweiten Bandpässen 92 bzw. 94 mit einer der zweiten Frequenz F2 entsprechenden Mittenfrequenz zugeführt. Es schließt sich in einer Signalverarbeitungseinheit 104 eine Weiterverarbeitung der elektrischen Signale I11, I12, I21 und I22 an, die im wesentlichen der im Zusammenhang mit den Ausführungsbeispielen von Figur 1 und 2 beschriebenen entspricht. Ebenso sind die im Ausführungsbeispiel von Figur 4 verwendete erste und zweite Wellenlänge $\lambda$1 bzw. $\lambda$2 sowie das Faraday-Element 10 analog zu den Ausführungsbeispielen der vorhergehenden Figuren bemessen.

Neben der in den Figuren 1 bis 4 beschriebenen transmissiven Ausführungsform mit jeweils einseitiger Lichteinspeisung sind auch reflektive Ausführungsformen der Anordnung oder Ausführungsformen mit gegenläufiger Lichteinspeisung in das Faraday-Element 10 möglich.

**Patentansprüche**

1. Verfahren zur optischen Erfassung eines elektrischen Stroms (I), bei dem

   - mindestens ein erstes elliptisch polarisiertes Lichtsignal (L1) mit einer ersten Polarisation und einer ersten Wellenlänge ($\lambda$1) sowie ein zweites elliptisch polarisiertes Lichtsignal (L2) mit einer zweiten Polarisation und einer von der ersten Wellenlänge ($\lambda$1) verschiedenen zweiten Wellenlänge ($\lambda$2) erzeugt werden,
   - das erste und das zweite Lichtsignal (L1, L2) in ein Faraday-Element (10) eingespeist werden,
   - die erste und die zweite Polarisation beim Durchlaufen des Faraday-Elements (10) in Abhängigkeit von dem elektrischen Strom (I) verändert werden, und
   - aus den Polarisationsänderungen der beiden Lichtsignale (L1, L2) ein Meßsignal (M) für den elektrischen Strom (I) abgeleitet wird,

   **dadurch gekennzeichnet,**

   - **daß** die erste und die zweite Polarisation pro Ampère des zu erfassenden elektrischen Stroms (I) jeweils um mindestens 0,0014° gedreht werden, und
   - **daß** zumindest eine der beiden Polarisationen unter dem Einfluß eines maximal zu erfassenden elektrischen Stroms (I) um mehr als 45° gedreht wird.

2. Verfahren nach Anspruch 1, **dadurch gekennzeichnet, daß** die erste und die zweite Polarisation in dem Faraday-Element (10) um einen ersten bzw. einen zweiten Drehwinkel ($\rho$1, $\rho$2) gedreht werden, wobei sich der erste und der zweite Drehwinkel ($\rho$1, $\rho$2) bei vorgegebenem elektrischen Strom (I) höchstens um den Faktor 2 unterscheiden.

3. Verfahren nach Anspruch 1 oder 2, **dadurch gekennzeichnet, daß** eine Wellenlängendifferenz zwischen der ersten und der zweiten Wellenlänge ($\lambda$1, $\lambda$2) von höchstens 15 % eines Mittelwerts der ersten und der zweiten Wellenlänge ($\lambda$1, $\lambda$2) vorgesehen wird.

4. Verfahren nach einem der vorhergehenden Ansprüche, **dadurch gekennzeichnet, daß** das erste und das zweite Lichtsignal (L1, L2) das Faraday-Element (10) gleichzeitig passieren.

5. Verfahren nach einem der Ansprüche 1 bis 3, **dadurch gekennzeichnet, daß** das erste und das zweite Lichtsignal (L1, L2) das Faraday-Element (10) zyklisch abwechselnd passieren.

6. Verfahren nach Anspruch 5, **dadurch gekennzeichnet, daß** das erste und das zweite Lichtsignal (L1, L2) aus einem optischen Wobbelsignal (L3) mit einer variierenden Wellenlänge ($\lambda$3) erzeugt werden, wobei die variierende Wellenlänge ($\lambda$3) zwischen der ersten Wellenlänge ($\lambda$1) und der zweiten Wellenlänge ($\lambda$2) durchgestimmt wird.

7. Verfahren nach Anspruch 6, **dadurch gekennzeichnet, daß** die variierende Wellenlänge ($\lambda$3) des optischen Wobbelsignals (L3) periodisch zwischen der ersten Wellenlänge ($\lambda$1) und der zweiten Wellenlänge ($\lambda$2) durchgestimmt wird.

8. Verfahren nach einem der Ansprüche 1 bis 5, **dadurch gekennzeichnet, daß** das erste und das zweite Lichtsignal (L1, L2) bei der Erzeugung mit einer ersten bzw. einer zweiten Frequenz (F1, F2) intensitätsmoduliert werden.

9. Anordnung zur optischen Erfassung eines elektrischen Stroms (I) in einem elektrischen Leiter (5), umfassend mindestens:

   - Sendemittel zur Erzeugung (11, 12, 13, 21, 31) mindestens eines ersten elliptisch polarisierten Lichtsignals (L1) mit einer ersten Polarisation und einer ersten Wellenlänge ($\lambda$1) sowie eines zweiten elliptisch polarisierten Lichtsignals (L2) mit einer zweiten Polarisation und einer von der ersten Wellenlänge ($\lambda$1) verschiedenen zweiten Wellenlänge ($\lambda$2),
   - ein dem elektrischen Leiter (5) zugeordnetes Faraday-Element (10), das von dem ersten und dem zweiten Lichtsignal (L1, L2) durchlaufen wird, wobei das Faraday-Element (10) in Abhängigkeit von dem zu erfassenden elektrischen Strom (I) und von einer wellenlängenabhängigen effektiven Verdet-Konstante (Veff) eine Änderung der ersten und der zweiten Polarisation bewirkt, und

- eine Auswerteeinheit (20) zur Ableitung eines Meßsignals (M) für den zu erfassenden elektrischen Strom (I) aus den Änderungen der ersten und der zweiten Polarisation,

**dadurch gekennzeichnet,**

- **daß** die effektive Verdet-Konstante (Veff) des Faraday-Elements (10) für beide Wellenlängen ($\lambda$1, $\lambda$2) einen Wert von mindestens 0,0014°/A aufweist, und
- **daß** das Faraday-Element (10) bei einem maximal zu erfassenden elektrischen Strom (I) zumindest eine der beiden Polarisationen um mehr als 45° dreht.

10. Anordnung nach Anspruch 9, **dadurch gekennzeichnet, daß** sich Werte der effektiven Verdet-Konstante (Veff) für die erste und die zweite Wellenlänge ($\lambda$1, $\lambda$2) höchstens um den Faktor 2 unterscheiden.

11. Anordnung nach Anspruch 9 oder 10, **dadurch gekennzeichnet, daß** die Sendemittel zur Erzeugung (11, 12, 13, 21, 31) des ersten und des zweiten Lichtsignals (L1, L2) ausgelegt sind, das erste und das zweite Lichtsignal (L1, L2) mit einer Wellenlängendifferenz von höchstens 15 % eines Mittelwerts der ersten und der zweiten Wellenlänge ($\lambda$1, $\lambda$2) zu erzeugen.

12. Anordnung nach einem der Ansprüche 9 bis 11, **dadurch gekennzeichnet, daß** die Sendemittel ausgelegt sind zur gleichzeitigen Einspeisung (21) des ersten und des zweiten Lichtsignals (L1, L2) in das Faraday-Element (10).

13. Anordnung nach einem der Ansprüche 9 bis 11, **dadurch gekennzeichnet, daß** die Sendemittel ausgelegt sind zur zyklisch abwechselnden Einspeisung (13, 51, 54) des ersten und des zweiten Lichtsignals (L1, L2) in das Faraday-Element (10)

14. Anordnung nach Anspruch 13, **dadurch gekennzeichnet, daß** die zur zyklisch abwechselnden Einspeisung (13, 51, 54) des ersten und des zweiten Lichtsignals (L1, L2) ausgelegten Sendemittel eine durchstimmbare Lichtquelle (13) zur Erzeugung eines optischen Wobbelsignals (L3) mit einer variierenden Wellenlänge ($\lambda$3) umfassen, wobei die variierende Wellenlänge ($\lambda$3) zwischen der ersten und der zweiten Wellenlänge ($\lambda$1, $\lambda$2) variiert.

15. Anordnung nach Anspruch 14, **dadurch gekennzeichnet, daß** die durchstimmbare Lichtquelle (13) ausgelegt ist zur Erzeugung eines optischen Wobbelsignals (L3) mit periodisch variierender Wellenlänge ($\lambda$3).

16. Anordnung nach einem der Ansprüche 9 bis 13, **dadurch gekennzeichnet, daß** die Sendemittel Modulationsmittel zur Intensitätsmodulation (62, 63) des ersten Lichtsignals (L1 mit einer ersten Frequenz (F1) und des zweiten Lichtsignals (L2) mit einer zweiten Frequenz (F2) umfassen.

**Claims**

1. Method for optically detecting an electric current (I), in which

- at least one first elliptically polarized light signal (L1) having a first polarization and a first wavelength ($\lambda$1) and also a second elliptically polarized light signal (L2) having a second polarization and a second wavelength ($\lambda$2), which is different from the first wavelength ($\lambda$1), are generated,
- the first and the second light signal (L1, L2) are fed into a Faraday element (10),
- the first and the second polarization are changed as a function of the electric current (I) upon passage through the Faraday element (10), and
- a measurement signal (M) for the electric current (I) is derived from the changes in polarization of the two light signals (L1, L2),

**characterized**

- **in that** the first and the second polarization are rotated in each case by at least 0.0014° per ampere of the electric current (I) to be detected, and
- **in that** at least one of the two polarizations is rotated by more than 45° under the influence of a maximum electric current (I) to be detected.

2. Method according to Claim 1, **characterized in that** the first and the second polarization are rotated in the Faraday element (10) by a first and, respectively, a second angle ($\rho$1, $\rho$2) of rotation, the first and the second angle ($\rho$1, $\rho$2) of rotation differing at most by the factor 2 given a predetermined electric current (I).

3. Method according to Claim 1 or 2, **characterized in that** a wavelength difference between the first and the second wavelength ($\lambda$1, $\lambda$2) of at most 15% of an average value of the first and second wavelengths ($\lambda$1, $\lambda$2) is envisaged.

4. Method according to one of the preceding claims, **characterized in that** the first and the second light signal (L1, L2) pass through the Faraday element (10) simultaneously.

5. Method according to one of Claims 1 to 3, **characterized in that** the first and the second light signal (L1, L2) pass through the Faraday element (10) cyclically alternately.

6. Method according to Claim 5, **characterized in that** the first and the second light signal (L1, L2) are generated from an optical swept-frequency signal (L3) having a varying wavelength ($\lambda$3), the varying wavelength ($\lambda$3) being tuned between the first wavelength ($\lambda$1) and the second wavelength ($\lambda$2).

7. Method according to Claim 6, **characterized in that** the varying wavelength ($\lambda$3) of the optical swept-frequency signal (L3) is tuned periodically between the first wavelength ($\lambda$1) and the second wavelength ($\lambda$2).

8. Method according to one of Claims 1 to 5, **characterized in that** the first and the second light signal (L1, L2) are intensity-modulated during generation with a first and, respectively, a second frequency (F1, F2).

9. Arrangement for optically detecting an electric current (I) in an electrical conductor (5), comprising at least:

    - transmitting means for generating (11, 12, 13, 21, 31) at least one first elliptically polarized light signal (L1) having a first polarization and a first wavelength ($\lambda$1) and also a second elliptically polarized light signal (L2) having a second polarization and a second wavelength ($\lambda$2), which is different from the first wavelength ($\lambda$1),
    - a Faraday element (10), which is assigned to the electrical conductor (5) and through which the first and the second light signal (L1, L2) pass, the Faraday element (10) effecting a change in the first and in the second polarization as a function of the electric current (I) to be detected and of a wavelength-dependent effective Verdet's constant (Veff), and
    - an evaluation unit (20) for deriving a measurement signal (M) for the electric current (I) to be detected from the changes in the first and in the second polarization,

    **characterized**

    - **in that** the effective Verdet's constant (Veff) of the Faraday element (10) has a value of at least 0.0014°/A for both wavelengths ($\lambda$1, $\lambda$2), and
    - **in that** the Faraday element (10) rotates at least one of the two polarizations by more than 45° given a maximum electric current (I) to be detected.

10. Arrangement according to Claim 9, **characterized in that** values of the effective Verdet's constant (Veff) for the first and the second wavelength ($\lambda$1, $\lambda$2) differ at most by the factor 2.

11. Arrangement according to Claim 9 or 10, **characterized in that** the transmitting means for generating (11, 12, 13, 21, 31) the first and the second light signal (L1, L2) are designed to generate the first and the second light signal (L1, L2) with a wavelength difference of at most 15% of an average value of the first and second wavelength ($\lambda$1, $\lambda$2).

12. Arrangement according to one of Claims 9 to 11, **characterized in that** the transmitting means are designed for simultaneously feeding (21) the first and the second light signal (L1, L2) into the Faraday element (10).

13. Arrangement according to one of Claims 9 to 11, **characterized in that** the transmitting means are designed for cyclically alternately feeding (13, 51, 54) the first and the second light signal (L1, L2) into the Faraday element (10).

14. Arrangement according to Claim 13, **characterized in that** the transmitting means designed for cyclically alternately feeding (13, 51, 54) in the first and the second light signal (L1, L2) comprise a tunable light source (13) for generating an optical swept-frequency signal (L3) having a varying wavelength ($\lambda$3), the varying wavelength ($\lambda$3) varying between the first and the second wavelength ($\lambda$1, $\lambda$2).

**15.** Arrangement according to Claim 14, **characterized in that** the tunable light source (13) is designed for generating an optical swept-frequency signal (L3) having a periodically varying wavelength ($\lambda$3).

**16.** Arrangement according to one of Claims 9 to 13, **characterized in that** the transmitting means comprise modulation means for intensity modulation (62, 63) of the first light signal (L1) with a first frequency (F1) and of the second light signal (L2) with a second frequency (F2).

**Revendications**

**1.** Procédé de mesure optique d'un courant électrique (I), dans lequel

- il est généré au moins un premier signal lumineux (L1) polarisé elliptiquement ayant une première polarisation et une première longueur d'onde ($\lambda$1) ainsi qu'un deuxième signal lumineux (L2) polarisé elliptiquement ayant une deuxième polarisation et une deuxième longueur d'onde ($\lambda$2) différente de la première longueur d'onde,
- les premier et deuxième signaux lumineux (L1, L2) sont introduits dans un élément de Faraday (10),
- les première et deuxième polarisations sont modifiées en fonction du courant électrique (I) lors de la traversée de l'élément de Faraday (10), et
- un signal (M) de mesure du courant électrique (I) est délivré à partir des variations de la polarisation des deux signaux lumineux (L1, L2).

**caractérisé en ce que**

- les première et deuxième polarisations pour chaque ampère du courant électrique (I) à mesurer tourne d'au moins 0,0014°, et
- au moins l'une des deux polarisations tourne de plus de 45° sous l'influence d'un courant électrique (I) maximal à mesurer.

**2.** Procédé selon la revendication 1, **caractérisé en ce que**, dans l'élément (10) de Faraday, la première polarisation est soumise à une rotation suivant un premier angle de rotation $\rho$1 et la deuxième polarisation est soumise à une rotation suivant un deuxième angle de rotation $\rho$2, les premier et deuxième angles ($\rho$1,$\rho$2) de rotation différant l'un de l'autre tout au plus d'un facteur 2 pour un courant électrique (I) prédéterminé.

**3.** Procédé selon la revendication 1 ou 2, **caractérisé en ce qu'**il est prévu une différence de longueur d'onde entre les première et deuxième longueurs d'onde ($\lambda$1, $\lambda$2) égale tout au plus à 15% d'une valeur moyenne des première et deuxième longueurs d'onde ($\lambda$1, $\lambda$2).

**4.** Procédé selon l'une des revendications précédentes, **caractérisé en ce que** les premier et deuxième signaux (L1, L2) lumineux traversent l'élément de Faraday (10) simultanément.

**5.** Procédé selon l'une des revendications 1 à 3, **caractérisé en ce que** les premier et deuxième signaux lumineux (L, L2) traversent l'élément de Faraday (10) alternativement de façon cyclique.

**6.** Procédé selon la revendication 5, **caractérisé en ce que** les premier et deuxième signaux lumineux (L1, L2) sont générés à partir d'un signal de vobulation optique (L3) avec une longueur d'onde variable ($\lambda$3), la longueur d'onde variable ($\lambda$3) étant réglée entre la première longueur d'onde ($\lambda$1) et la deuxième longueur ($\lambda$2).

**7.** Procédé selon la revendication 6, **caractérisé en ce que** la longueur d'onde variable ($\lambda$3) du signal de vobulation optique (L3) est réglée périodiquement entre la première longueur d'onde ($\lambda$1) et la deuxième longueur d'onde ($\lambda$2).

**8.** Procédé selon l'une des revendications 1 à 5, **caractérisé en ce que** les premier et deuxième signaux lumineux (L1, L2) sont générés en étant modulés en intensité avec respectivement une première fréquence et une deuxième fréquence (F1, F2).

9. Dispositif de mesure optique d'un courant électrique (I) dans un conducteur électrique (5), comportant au moins

   - des moyens d'émission (11, 12, 13, 21, 31) destinés à générer au moins un premier signal lumineux (L1) polarisé elliptiquement ayant une première polarisation et une première longueur d'onde ($\lambda$1) ainsi qu'un deuxième signal lumineux (L2) polarisé elliptiquement ayant une deuxième polarisation et une deuxième longueur d'onde ($\lambda$2) différente de la première longueur d'onde ($\lambda$1),
   - un élément de Faraday (10) associé au conducteur électrique (5) et qui est traversé par les premier et deuxième signaux lumineux (L1, L2), l'élément de Faraday (10) provoquant une variation des première et deuxième polarisations en fonction du courant électrique à mesurer (I) et d'une constante de Verdet efficace (Veff) qui est fonction de la longueur d'onde, et
   - une unité d'exploitation (20) destinée à délivrer un signal de mesure (M) du courant électrique à mesurer (I) à partir des variations des première et deuxième polarisations,

   **caractérisé en ce que**

   - la constante de Verdet efficace (Veff) de l'élément de Faraday (10) pour les deux longueurs d'onde ($\lambda$1, $\lambda$2) a une valeur d'au moins 0,0014°/A, et
   - l'élément de Faraday (10) fait tourner de plus de 45° au moins une des deux polarisations pour un courant électrique maximal à mesurer (I).

10. Dispositif selon la revendication 9, **caractérisé en ce que** des valeurs de la constante de Verdet efficace (Veff) pour les première et deuxième longueurs d'onde ($\lambda$1, $\lambda$2) diffèrent tout au plus du facteur 2.

11. Dispositif selon la revendication 9 ou 10, **caractérisé en ce que** les moyens d'émission (11, 12, 13, 21, 31) destinés à générer les premier et deuxième signaux lumineux (L1, L2) sont conçus pour générer les premier et deuxième signaux lumineux (L1, L2) avec une différence de longueur d'onde égale tout au plus à 15% d'une valeur moyenne des première et deuxième longueurs d'onde ($\lambda$1, $\lambda$2).

12. Dispositif selon l'une des revendications 9 à 11, **caractérisé en ce que** les moyens d'émission sont conçus pour introduire simultanément (21) les premier et deuxième signaux lumineux (L1, L2) dans l'élément de Faraday (10).

13. Dispositif selon l'une des revendications 9 à 11, **caractérisé en ce que** les moyens d'émission sont conçus pour introduire alternativement suivant un cycle (13, 51, 54) les premier et deuxième signaux lumineux (L1, L2) dans l'élément de Faraday (10).

14. Dispositif selon la revendication 13, **caractérisé en ce que** les moyens d'émission conçus pour introduire alternativement suivant un cycle (13, 51, 54) les premier et deuxième signaux lumineux (L1, L2) comportent une source lumineuse réglable (13) destinée à générer un signal de vobulation optique (L3) de longueur d'onde variable ($\lambda$3), la longueur d'onde variable ($\lambda$3) variant entre la première et la deuxième longueur d'onde ($\lambda$1, $\lambda$2).

15. Dispositif selon la revendication 14, **caractérisé en ce que** la source lumineuse réglable (13) est conçue pour générer un signal de vobulation optique (L3) de longueur d'onde variable périodiquement ($\lambda$3).

16. Dispositif selon l'une des revendications 9 à 13, **caractérisé en ce que** les moyens d'émission comportent des moyens (62, 63) de modulation en intensité du premier signal lumineux (L1) à une première fréquence (F1) et du deuxième signal lumineux (L2) à une deuxième fréquence (F2).

**FIG 1**

FIG 2

FIG 3

**FIG 4**